# EUROPÄISCHE PATENTSCHRIFT

(11) **EP 1 480 291 B1**
(45) Veröffentlichungstag und Bekanntmachung des Hinweises auf die Patenterteilung: **10.02.2010**
(21) Anmeldenummer: 04011712.9
(22) Anmeldetag: 18.05.2004
(51) Int. Cl.: H01R 12/04

(54) **Elektronische Baugruppe**
Electronic assembly
Assemblage électronique

(30) Priorität: 19.05.2003 DE 10322840
(43) Veröffentlichungstag der Anmeldung: 24.11.2004
(73) Patentinhaber: Muck, Siegfried, 87437 Kempten (DE)
(72) Erfinder: Muck, Siegfried, 87437 Kempten (DE); König, Sibyll, 86706 Weicherring (DE); Kleikemper, Vera, 85057 Ingolstadt (DE)
(74) Vertreter: Petra, Elke

(56) Entgegenhaltungen:
- EP-A2- 1 283 664
- JP-A- 6 097 608
- US-A- 5 148 962

## Beschreibung

Die Erfindung betrifft eine elektronische Baugruppe nach dem Oberbegriff des Patentanspruchs 1, eine zum Einsatz in dieser Baugruppe geeignete Leiterfolie nach dem Oberbegriff von Patentanspruch 13 und ein Verfahren zur Herstellung der elektronischen Baugruppe gemäß dem Oberbegriff des Patentanspruchs 16.

In vielen Bereichen werden elektronische Baugruppen für unterschiedliche Anwendungen und Aufgaben eingesetzt; beispielsweise sind elektronische Baugruppen als Steuergeräte zur Verarbeitung von Messsignalen und/oder zur Steuerung bestimmter Funktionen oder Komponenten vorgesehen. Derartige elektronische Baugruppen können sowohl eine Leiterplatte mit einer Leiterbahnstruktur als auch eine Leiterfolie mit einer Leiterbahnstruktur aufweisen, die jeweils zur Aufnahme von Bauteilen der elektronischen Baugruppe und/oder zur Ausbildung von Kontaktverbindungen vorgesehen sind. Hierbei muß eine elektrisch leitende Verbindung zwischen der Leiterbahnstruktur der Leiterplatte und der Leiterbahnstruktur der Leiterfolie hergestellt werden; dies wird in der Regel mittels eines von der Leiterbahnstruktur der Leiterplatte ausgehenden Steckverbinders realisiert, der durch Crimpen mit der Leiterbahnstruktur der Leiterfolie verbunden wird. Eine derartige elektrisch leitende Verbindung mittels eines Steckverbinders bedingt jedoch hohe Kosten sowie einen hohen Fertigungsaufwand und Montageaufwand.

Die JP 06/097608 beschreibt eine Maßnahme zur Verbesserung der Stabilität und Genauigkeit eines Kontaktpunkts an flexiblen Leiterplatten. Damit soll eine lösbare, berührende, elektrische Kontaktierung (keine feste Lötverbindung) von mehreren, auf einer flexiblen Leiterplatte angeordneten Kontaktpunkten mit einer gegenüberliegenden Leiterplatte verbessert werden. Dabei ist eine mit Stützwarzen ausgebildete Kunstharz-Hilfsplatte vorgesehen, die mit der flexiblen Leiterplatte, bestehend aus einer dünnen Kunststoff-Trägerfolie und darauf befindlicher Leiterbahnstruktur zusammengefügt gleichzeitig die Kontaktpunkte formt und ein Verkleben über eine Klebezwischenschicht mit der Leiterplatte erfolgt. Dies hat jedoch den Nachteil, dass sich dabei die Steifigkeit von der flexiblen Leiterplatte erhöht. Die dabei angestrebte Verbesserung der Höhengleichheit aller Kontaktpunkte ist für eine Lötverbindung einer flexiblen Leiterplatte nicht erforderlich. Es kommt im Gegenteil dazu darauf an, dass durch Einschnitte und Trennungen der einzelnen Leiterbahnen mit Kontaktpunkten zueinander die Weichheit und Flexibilität einer biegeschlaffen Leiterplatte nochmals verstärkt werden. Für eine Lötverbindung ist dieser Leiterplatten-Aufbau somit weder vorgesehen noch geeignet, da hier eine unterstützende Anfederung eines jeden einzelnen Kontaktpunktes zum Eindrücken in die Lotschmelze nicht mehr möglich ist.

Aus der EP 1 283 664 A2 ist zudem ein mit einer Lötverbindung mit einem elektronischen Bauteil, z. B. Leiterplatte, zu verbindender Flachleiter bekannt, der einen zu einer vom Bauteil wegweisenden Flachseite (der äußeren Unterseite mit isolierender Trägerfolie) des Flachbandleiters hin (konkav) aufgebogenen Randbereich eines Durchbruches hat, der auf der gegenüberliegenden Seite einen lötbaren, elektrisch leitenden und mit einer Leiterbahn des Flachleiters verbundenen Kontaktbereich aufweist. Zum Verlöten werden die Kontaktbereiche des Flachleiters und des Bauteils flach aufeinanderliegend so positioniert, daß sich der nach außen kraterförmig aufgebogene Randbereich des Flachleiterdurchbruches gegenüber dem Kontaktbereich des Bauteils, auf dem ein Lötdepot aufgebracht ist, befindet und von diesem wegweist. Durch die Erhitzung des Lots über eine auf oder über den aufgebogenen Randbereich wirksame Wärmequelle schmilzt das Lot und soll aufgrund der Kapillarwirkung des aufgebogenen Randbereichs des Flachleiterdurchbruches eine nach außen kriechende, ringförmig umlaufende Lotverbindung bilden. Diese geometrische Ausgestaltung hat den Nachteil, dass die Lotschmelze aufgrund der Kapillarwirkung vom Erwärmungsmittelpunkt weg, hin zu einem weniger erwärmten Randbereich fließen soll. Abgesehen davon, dass hier die Gefahr eines unkontrollierten Lotflusses im Kontaktbereich besteht, mit unterschiedlichen Wärmekapazitäten der zu verbindenden Teile und einer Überhitzung und dadurch einer Zerstörung der Isolation des Flachleiters, wird durch das flache Aufeinanderliegen der zu verlötenden Teile ein Kapillareffekt verursacht, der zu einer unregelmäßigen Verteilung des Lots führt und nicht zu dem angestrebten gleichmäßigen Lot-Meniskus. Dies kann zu einer Verkriechung bis hin zu einer Tröpfchenbildung im Randbereich der Verbindung führen, die im Extremfall einen Kurzschluß verursachen kann.

Der Erfindung liegt daher die Aufgabe zugrunde, eine elektronische Baugruppe oben genannter Gattung anzugeben, die einen einfachen Aufbau, eine einfachen Fertigung, gering Kosten, eine hohe Zuverlässigkeit und vorteilhafte Eigenschaften bezüglich der elektrischen leitenden Verbindung zwischen Leiterplatte und Leiterfolie besitzt. Des weiteren soll ein Verfahren zur Herstellung einer derartigen Baugruppe und eine für ein solches Verfahren bzw. eine derartige Baugruppe geeignete Leiterfolie geschaffen werden.

Diese Aufgabe wird jeweils erfindungsgemäß gelöst durch die Merkmale der unabhängigen Patentansprüche 1, 13 und 16. Vorteilhafte Ausgestaltungen der Erfindung sind Gegenstand der sich an die unabhängigen Ansprüche anschließenden weiteren Patentansprüche.

Erfindungsgemäß ist zur Realisierung einer reproduzierbaren, prozesssicheren Lötverbindung als elektrisch leitende Verbindung zwischen der Leiterbahnstruktur der Leiterplatte und der Leiterbahnstruktur der Leiterfolie an der jeweils für die Kontaktierung vorgesehenen Kontaktstelle in die Leiterfolie eine zu dem Kontaktfleck (Lotdepot) auf der Leiterplatte korrespondierende, als Abstandshalter überstehende Ausformung (vorzugsweise eine Ausprägung) in Form einer Kappe auf der zur Leiterplatte weisenden Oberseite der Leiterfolie eingebracht, die auf der gegenüberliegenden Unterseite der Leiterfolie eine konkave Einbuchtung bildet. Diese Ausformung bewirkt beim Lötprozess einen definierten Fluss des aufgeschmolzenen Lots des Kontaktflecks (Lotdepots) auf einer bestimmten Bahn und die Ausbildung mehrerer Kontaktzonen innerhalb einer Kontaktstelle und damit einen guten Stromübergang. Die Kontaktstelle ist dabei an einer elektronischen Bauteilen der Leiterplatte gegenüberliegenden Oberflächenseite vorgesehen, wobei die Erwärmung des Lots vorzugsweise von der anderen Oberflächenseite her erfolgt, d. h. der Seite, auf der die elektronischen Bauteile angeordnet sind, also insbesondere durch die Leiterplatte hindurch.

Auf die Leiterplatte werden die für die Kontaktierung mit der Leiterfolie vorgesehenen Kontaktflecken (Lotdepots) als Teil der Leiterbahnstruktur der Leiterplatte aufgebracht; die Bauteile der elektronischen Baugruppe werden auf Aufnahmeflächen der Leiterbahnstruktur der Leiterplatte aufgebracht und insbesondere durch Reflowlöten oder Schwalllöten mit den Aufnahmeflächen und folglich mit der Leiterbahnstruktur der Leiterplatte leitend verbunden. Die Leiterbahnstruktur der Leiterplatte und damit die Leiterbahnen sowie die Kontaktflecken als Lotdepot bestehen vorzugsweise aus einem Metall, zumindest aber weisen sie eine metallische Oberfläche auf, beispielsweise eine verzinnte Oberfläche.

Die auf einem Schaltungsträger aufgebrachte, von mindestens einer Isolationsschicht bedeckte Leiterbahnstruktur der Leiterfolie (beispielsweise besteht die Leiterbahnstruktur der Leiterfolie aus Kupfer) muß zumindest in einem für die Kontaktierung mit der Leiterbahnstruktur der Leiterplatte vorgesehenen Kontaktierungsbereich zugänglich sein, d.h. die Leiterbahnstruktur ist in diesem Kontaktierungsbereich einseitig oder beidseitig freigelegt. Als Leiterfolien können hierbei beispielsweise entweder flexible gedruckte Flachkabel ("Flexible Printed Circuit" FPC) eingesetzt werden - bei diesen ist die Leiterbahnstruktur direkt auf einem flexiblen Schaltungsträger aufgebracht und von einer Isolationsfolie abgedeckt - oder aber flexible, beispielsweise mittels Laminieren oder Extrudieren hergestellte, Flachkabel ("Flexible Flat Cable" FFC) - bei diesen ist eine die Leiterbahnstruktur tragende Schaltfolie als Schaltungsträger zwischen zwei Isolationsfolien angeordnet. In die Leiterfolie und damit insbesondere in die Leiterbahnen der Leiterfolie sind im Kontaktierungsbereich an den zur Kontaktierung mit der Leiterbahnstruktur der Leiterplatte vorgesehenen Kontaktstellen mittels eines Hilfswerkzeugs Ausformungen eingebracht, insbesondere Ausprägungen, die beispielsweise mittels eines Prägewerkzeugs (Stempels) nach dem Freilegen des Kontaktierungsbereichs vorzugsweise durch Tiefziehen in die entsprechenden Leiterbahnen der Leiterbahnstruktur der Leiterfolie eingebracht werden. Die Form der Ausformungen kann hierbei beliebig gewählt werden, beispielsweise rund und insbesondere elliptisch; vorzugsweise wird die Form des jeweiligen Kontaktflecks (Lotdepots) auf der Leiterplatte an die Form der Ausformungen angepaßt, d.h. bei einer elliptischen Form der Ausformungen wird auch die Form des korrespondierenden Kontaktflecks (Lotdepots) elliptisch gewählt. Vorzugsweise wird auch die Größe der beiden Kontaktflächen an der Kontaktstelle zwischen der Leiterbahnstruktur der Leiterfolie und der Leiterbahnstruktur der Leiterplatte gleich gewählt, d.h. die Größe der Ausformung in der Leiterfolie und des korrespondierenden Kontaktflecks (Lotdepots) wird gleich gewählt. Die Ausgestaltung der einzelnen Leiterbahnen der Leiterbahnstruktur von Leiterfolie und Leiterplatte (insbesondere die Breite der Leiterbahnen) wird vorzugsweise zumindest im Kontaktierungsbereich gleich gewählt; demnach besitzen zumindest im Kontaktierungsbereich die beiden an der Kontaktstelle mit Lot zu verbindenden stromführenden Flächen, d.h. die jeweilige Leiterbahn der Leiterbahnstruktur der Leiterfolie und die jeweilige Leiterbahn der Leiterbahnstruktur der Leiterplatte die gleiche Breite. Durch diese Maßnahmen wird beim Lötprozeß ein definierter Lotfluß bei der Verbindung der beiden stromführenden Flächen ermöglicht und in vorteilhafter Weise ein unkontrollierter Lotfluß oder eine unkontrollierte Verteilung des Lots verhindert.

Bei mehreren nebeneinander liegenden Leiterbahnen der Leiterbahnstruktur der Leiterfolie werden die Leiterbahnen zumindest im Kontaktierungsbereich lateral voneinander getrennt, beispielsweise durch einen Freischnitt, wodurch Freiraum für Vergasungen während des Lötprozesses geschaffen wird.

In einer Montagevorrichtung wird die Leiterfolie unterhalb der Leiterplatte derart angeordnet, dass die Leiterbahnstruktur der Leiterfolie und die Leiterbahnstruktur der Leiterplatte einander zugewandt sind. Die Leiterfolie wird derart bezüglich der Leiterplatte positioniert, dass die Leiterbahnstruktur der Leiterfolie im Kontaktierungsbereich wie gewünscht bezüglich der Leiterbahnstruktur der Leiterplatte angeordnet ist; hierbei ist eine exakte Positionierung der beiden mit Lot zu verbindenden stromführenden Flächen zueinander erforderlich, insbesondere damit auch eine exakte Positionierung der beiden Kontaktflächen der Ausformungen auf der Leiterfolie einerseits und der korrespondierenden Kontaktflecken auf der Leiterplatte andererseits zueinander gewährleistet ist. Vorzugsweise wird hierbei die Positionierung unter Zuhilfenahme von auf der Leiterfolie und/oder auf der Leiterplatte angeordneten und/oder an der Montagevorrichtung ausgebildeten Positionierhilfen durchgeführt, beispielsweise mittels in Öffnungen oder Aufnehmungen in der Leiterfolie und/oder der Leiterplatte eingreifenden Positionierstiften. Auf die Leiterplatte wird eine beispielsweise als Aluminiumplatte ausgebildete Andrückvorrichtung der Montagevorrichtung aufgelegt, die als Niederhalter den Verbund aus Leiterplatte und Leiterfolie mechanisch fixiert. Die Leiterfolie ist auf eine Auflagevorrichtung der Montagevorrichtung aufgelegt, die im Bereich der Ausformungen jeweils ein Andrückelement mit Feder aufweist; hierdurch werden die Leiterfolie und damit die im Kontaktierungsbereich freigelegte Leiterbahnstruktur der Leiterfolie und insbesondere die Ausformungen auf der Leiterfolie gegen die korrespondierenden Kontaktflecken auf der Leiterplatte gedrückt, so dass sich die Leiterbahnstrukturen von Leiterfolie und Leiterplatte im Kontaktierungsbereich und damit die beiden Kontaktflächen an der zu bildenden Kontaktstelle berühren. Somit wird einerseits die Voraussetzung zur Bildung eines umlaufenden Meniskus des Lotmittels beim Aufschmelzen des jeweiligen Kontaktflecks (Lotdepots) geschaffen, andererseits wird die Bildung eines Luftspalts zwischen den beiden Kontaktflächen an der zu bildenden Kontaktstelle vermieden, so dass keine Gefahr von Lufteinschlüssen und damit auch von Lunkerbildungen besteht; weiterhin kann hierdurch die Verbindung der beiden Kontaktflächen und damit auch der beiden zu kontaktierenden Leiterbahnen (die beiden mit Lot zu verbindenden stromführenden Flächen) mit einer geringen Lotmenge realisiert werden.

Nach der Positionierung und Fixierung von Leiterplatte und Leiterfolie wird das jeweilige Lotdepot des mindestens einen Kontaktflecks mittels eines selektiven Lötprozesses erwärmt und aufgeschmolzen, wobei der Lotfluss beim Aufschmelzen aufgrund der gewählten Vorgabe der geometrischen Gegebenheiten definiert verläuft. Durch die Materialverbindung der beiden Kontaktflächen, d.h. des aufgeschmolzenen Lots des Kontaktflecks mit der Ausformung auf der Leiterbahnstruktur der Leiterfolie, wird die jeweilige Kontaktstelle zwischen den beiden zu kontaktierenden Leiterbahnen (stromführenden Flächen) als qualitativ hochwertige Lötverbindung ausgebildet, insbesondere auch durch die Ausbildung mehrerer Kontaktzonen und damit wirksamer Stromübergänge zwischen den beiden Kontaktflächen innerhalb einer Kontaktstelle. Als selektiver Lötprozess kann insbesondere das Laserlöten unter Verwendung eines fokussierten Laserstrahls eingesetzt werden, bei dem ein über eine Fokussiereinrichtung aufgeweiteter Laserstrahl das Material des Kontaktflecks selektiv erwärmt; die Strahlform und damit das Einbringen der thermischen Energie (beispielsweise beim Laserlöten durch Vorgabe des Laser-Brennpunkts) wird entsprechend der Form der Ausformung auf der Leiterfolie vorgegeben, so dass eine genaue Fokussierung des zu erwärmenden Bereichs und damit ein präzises Aufschmelzen des Lotdepots ermöglicht wird, ohne dass benachbarte Bereiche insbesondere auf der Leiterfolie unerwünschter weise übermäßig erwärmt werden. Vorzugsweise wird die auf der Ausformung auf der Leiterfolie gegenüberliegenden Unterseite der Leiterfolie gebildete konkave Einbuchtung in der Leiterfolie beim Einbringen der thermischen Energie durch die vorzugsweise entsprechend der Ausformung geformte Oberseite des Andrückelements der Auflagevorrichtung der Montagevorrichtung formgetreu ausgefüllt. Da der Kontaktfleck (das Lotdepot) kleinflächig ausgebildet ist, wird eine geringe thermische Energie (beispielsweise eine geringe Laserleistung) zum Aufschmelzen des Lotdepots benötigt, woraus auch eine geringe thermische Belastung für die Leiterplatte und die Leiterfolie resultiert. Weiterhin kann durch entsprechende Wahl des Materials des Andrückelements ein Ableiten der beim Lötprozess entstehenden Wärme (Kontaktwärme) von der Leiterfolie weg gewährleistet werden. Somit können hierdurch auch lokale Überhitzungen an der jeweiligen Kontaktstelle und damit Schädigungen der Leiterfolie (beispielsweise infolge schädlicher Auswirkungen auf den zur Verbindung der einzelnen Folien der Leiterfolie benötigten Klebstoff) vermieden werden.

Auf der Leiterfolie können Anschlußkontakte für die externe Kontaktierung der elektronischen Baugruppe ausgebildet werden, beispielsweise können die Anschlußkontakte durch Crimpen oder Schweißen oder Löten auf den Schaltungsträger der Leiterfolie aufgebracht werden; insbesondere können mehrere Anschlußkontakte zu Kontaktbereichen zusammengefaßt und beispielsweise in einem gemeinsamen Gehäuseanschluß integriert werden. An die Anschlußkontakte und insbesondere an einen Gehäuseanschluß können geeignete Anschlußkomponenten angeschlossen werden, insbesondere Anschlußleitungen oder Anschlussstecker.

Zum Schutz der Bauteile beim Einsatz der elektronischen Baugruppe kann ein Gehäusekörper vorgesehen werden, insbesondere ein allseitig geschlossenes Gehäuse.

Die elektronische Baugruppe vereinigt mehrere Vorteile in sich:
- Die Kontaktierung der Leiterbahnstruktur der Leiterplatte und der Leiterbahnstruktur der Leiterfolie mittels einer Lötverbindung kann auf einfache Weise ohne das Erfordernis zusätzlicher Kontaktelemente realisiert werden. Die Lötverbindung zur Verbindung der beiden Kontaktflächen und damit der beiden stromführenden Flächen als Leiterbahn auf der jeweiligen Leiterbahnstruktur kann hierbei kleinflächig, mit einem geringen Lotdepot, mit einer geringen thermischen Energie (und damit auch einer geringen thermischen Belastung), ohne Lunkerbildung oder Brückenbildung und damit der Gefahr von Kurzschlüssen zwischen benachbarten Leiterbahnen realisiert werden, da anhand der Vorgabe der Prozessparameter Zeitdauer und thermische Einstrahlung (insbesondere hinsichtlich deren Energie und Fokussierung) sowie der Formgebung und Dimensionierung der beiden zu verbindenden stromführenden Flächen und der beiden Kontaktflächen die erforderliche thermische Energie präzise eingekoppelt werden und hierdurch der zu erwärmende Bereich definiert vorgegeben werden kann. Somit kann auch die thermische Belastung für die elektronische Baugruppe gering gehalten werden, wodurch die Gefahr von Schädigungen der Leiterfolie und der elektronischen Bauteile der elektronischen Baugruppe vermieden wird.
- Die Lötverbindung gewährleistet somit einen guten elektrischen Kontakt zwischen der Leiterbahnstruktur der Leiterplatte und der Leiterbahnstruktur der Leiterfolie, insbesondere auch beim Einsatz der elektronischen Baugruppe unter schwierigen äußeren Bedingungen; sie kann kostengünstig und automatisiert realisiert werden, insbesondere bei gleichzeitiger Ausbildung mehrerer Kontaktstellen, wobei dann vorzugsweise mehrere Laserstrahlquellen eingesetzt werden.

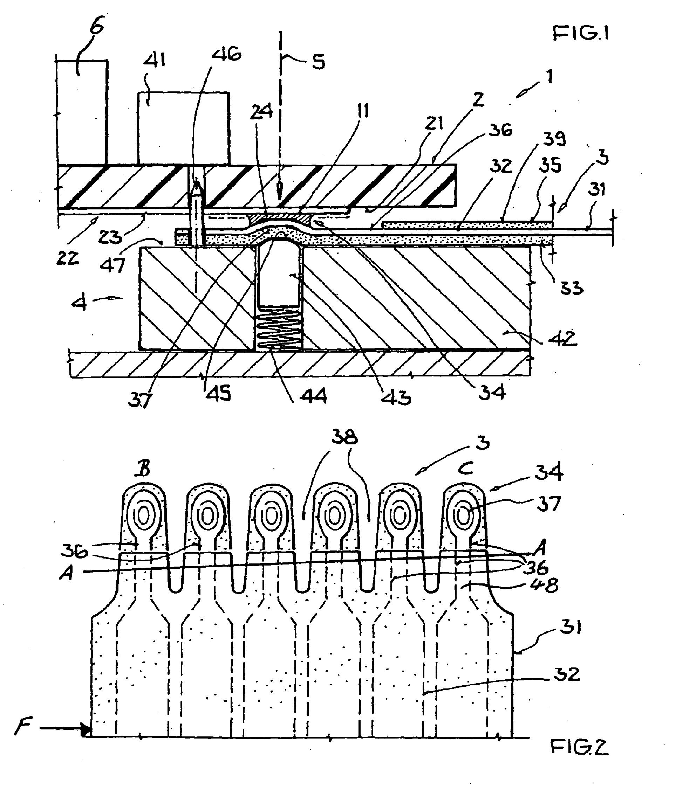

Im Zusammenhang mit den Zeichnungen der Fig. 1 bis 4 werden nachfolgend die erfindungsgemäße elektronische Baugruppe, das erfindungsgemäße Montageverfahren und die dazu geeignete erfindungsgemäße Leiterfolie anhand eines nicht einschränkend aufzufassenden Ausführungsbeispiels näher erläutert werden.
In den Fig. 1 und 3 ist in einem Ausschnitt eine Schnittzeichnung der elektronischen Baugruppe 1 mit dem Verbund aus Leiterplatte 2 und Leiterfolie 3 bei der Realisierung der elektrischen Kontaktierung der Leiterplatte 2 und der Leiterfolie 3 durch Ausbildung einer Kontaktstelle 11 dargestellt.

Die Fig. 2 zeigt eine Draufsicht auf den Kontaktierungsbereich 34 der Leiterfolie 3 mit mehreren nebeneinander liegenden Leiterbahnen 36 der Leiterbahnstruktur 32 der Leiterfolie 3.
In Zusammenhang mit Fig. 4 wird die bevorzugte Erwärmung der Kontaktstelle 11, insbesondere mittels eines Laserstrahls 5, näher erläutert.

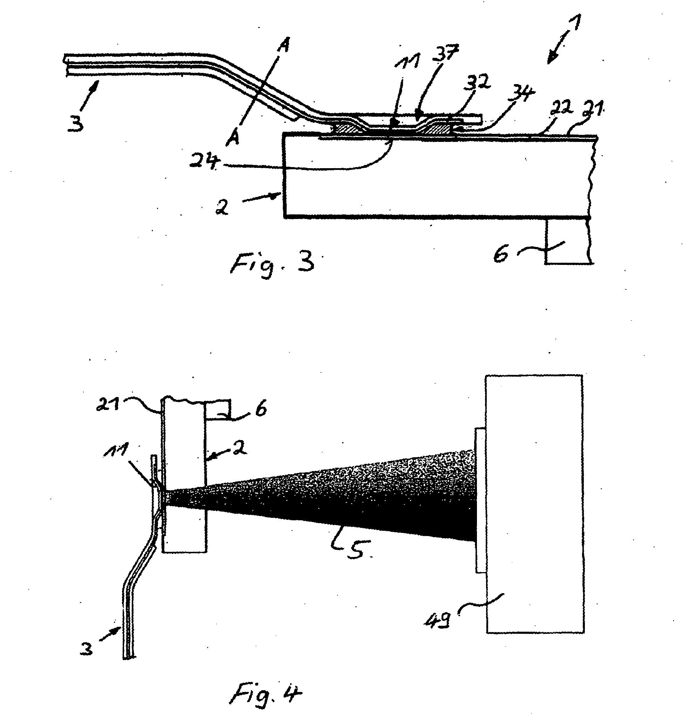

Gemäß Fig. 1 und 3 ist auf einer Oberflächenseite 21 der Leiterplatte 2 eine Leiterbahnstruktur 22 mit Leiterbahnen 23 ausgebildet; auf der Leiterbahnstruktur 22 der Leiterplatte 2 ist mindestens ein Lotdepot als Kontaktfleck 24 zur Ausbildung mindestens einer Kontaktstelle 11 vorgesehen, der üblicherweise während der Heißluftverzinnung bzw. zur Erhöhung des Lotdepots in einem anschließenden Lotpastendruck aufgebracht und in einem Reflowprozess aufgeschmolzen wird; beispielsweise sind auf der Leiterbahnstruktur 22 der Leiterplatte 2 mehrere Kontaktflecken 24 zur Ausbildung mehrerer Kontaktstellen 11 vorgesehen. Die Bauteile der elektronischen Baugruppe 1 werden beispielsweise auf die Oberflächenseite 21 der Leiterplatte 2 aufgebracht und beispielsweise durch Reflowlöten mit der Leiterbahnstruktur 22 der Leiterplatte 2 elektrisch leitend verbunden.

Die in Fig. 2 dargestellte, erfindungsgemäße Leiterfolie 3 umfasst eine als Trägerkörper fungierende erste Isolationsfolie 33, eine als Abdeckung fungierende zweite Isolationsfolie 35 und eine als Schaltungsträger fungierende, eine Leiterbahnstruktur 32 mit Leiterbahnen 36, beispielsweise aus Kupfer, aufweisende Schaltfolie 31, die zwischen der ersten Isolationsfolie 33 und der zweiten Isolationsfolie 35 angeordnet ist. In einem Kontaktierungsbereich 34 der Leiterfolie 3 ist zumindest die erste Isolationsfolie 33, optional auch die zweite Isolationsfolie 35, entfernt und somit die Leiterbahnstruktur 32 der Schaltfolie 31 einseitig oder auch beidseitig freigelegt. Im Kontaktierungsbereich 34 der Leiterfolie 3 sind in die Leiterfolie 3 und insbesondere in die Leiterbahnen 36 der Schaltfolie 31 auf der Oberseite 39 der Leiterfolie 3 erfindungsgemäß überstehende Ausformungen 37 eingebracht; beispielsweise ist im Kontaktierungsbereich 34 der Leiterfolie 3 in jede Leiterbahn 36 der Schaltfolie 31 als Ausformung 37 jeweils eine Ausprägung mittels eines Prägewerkzeugs eingebracht. Die Ausformungen 37 besitzen beispielsweise eine halbellipsoidische Form, beispielsweise mit einer Länge von 1,8 mm, einer Breite von 1,4 mm und einer Höhe von 0,1 mm, wobei der Ellipsoid vorzugsweise im Kontaktierungsbereich 34 abgeflacht ist, so dass die Ausformungen 37, wie aus Fig. 3 ersichtlich, an der Kontaktstelle 11 eine flächige Kappe aufweisen. Demzufolge ergibt sich kein punkt- sondern ein flächenförmiger Kontakt der Leiterfolie 3 mit den Kontaktflecken 24 der Leiterplatte 2, wodurch insbesondere auch der Wärmeübergang zum an dieser Stelle vorgesehenen Lotdepot verbessert wird. Die Form und die Größe der Kontaktflecken 24 auf der Leiterbahnstruktur 22 der Leiterplatte 2 wird hierbei entsprechend der Form und Größe der Ausformungen 37 gewählt; demzufolge weisen die Kontaktflecken 24 auf der Leiterbahnstruktur 22 der Leiterplatte 2 beispielsweise eine halbellipsoidische Form mit einer Länge von 1,8 mm und einer Breite von 1,2mm und eine Höhe von etwa 150 µm auf.

Gemäß der Fig. 2 ist zumindest im Bereich der Ausformungen 37, vorzugsweise zumindest im Kontaktierungsbereich 34, die Breite der Leiterbahnen 36 der Leiterbahnstruktur 32 der Leiterfolie 3 entsprechend der Breite der Leiterbahnen 23 der Leiterbahnstruktur 22 der Leiterplatte 2 gewählt, d.h. die Leiterbahnen 36 der Leiterbahnstruktur 32 der Leiterfolie 3 besitzen im Bereich der Ausformung 37, vorzugsweise jedoch zumindest im Kontaktierungsbereich 34, eine geringere Breite als im übrigen Bereich der Leiterfolie 3. Beispielsweise besitzen die Leiterbahnen 23 der Leiterbahnstruktur 22 der Leiterplatte 2 eine Breite von 1,2 mm, die Leiterbahnen 36 der Leiterbahnstruktur 32 der Leiterfolie 3 im Bereich der Ausformung 37, vorzugsweise jedoch zumindest im Kontaktierungsbereich 34, eine Breite von 1,4 mm, im abgewinkelten Bereich 48 eine Breite von 0,6 mm und im übrigen Bereich der Leiterfolie 3 eine Breite von 2 mm.

Bei einer mehrere nebeneinander liegende Leiterbahnen 36 aufweisenden Leiterbahnstruktur 32 der Leiterfolie 3 ist gemäß der Fig. 2 im Bereich der Ausformungen 37, vorzugsweise auch im gesamten Kontaktierungsbereich 34, jeweils ein Freischnitt 38 zwischen die einzelnen Leiterbahnen 36 der Leiterbahnstruktur 32 der Leiterfolie 3 eingebracht. Weiterhin ist die Leiterfolie 3, wie aus Fig. 3 ersichtlich, vorzugsweise nicht eben, sondern im Bereich des Freischnitts 38, etwa entlang der Linie A-A, zumindest zweifach abgewinkelt. Dies hat den besonderen Vorteil, dass bei Angriff einer Kraft F auf die Leiterfolie 3 die äußeren Lötpunkte B und C der Kontaktierungsbereiche 34 entlastet werden, wodurch deren Abscheren weitestgehend vermieden werden kann.

Zur elektrisch leitenden Verbindung der Leiterbahnstruktur 32 der Leiterfolie 3 mit der Leiterbahnstruktur 22 der Leiterplatte 2 wird die mit elektronischen Bauteilen 6 bestückte Leiterplatte 2 und die mit den Ausformungen 37 versehene Leiterfolie 3 in eine Montagevorrichtung 4 (siehe Fig. 1) eingebracht, wobei die Leiterplatte 2 oberhalb der Leiterfolie 3, d.h. auf der Oberseite 39 der Leiterfolie 3 angeordnet ist und die Leiterbahnstruktur 22 der Leiterplatte 2 zur Leiterbahnstruktur 32 der Leiterfolie 3 hin orientiert ist. Auf die Leiterplatte 2 ist eine Andrückvorrichtung 41 der Montagevorrichtung 4 aufgelegt, beispielsweise ein als Aluminiumplatte ausgebildeter Niederhalter. Die Leiterfolie 3 liegt auf einer Auflagevorrichtung 42 der Montagevorrichtung 4 auf, die im Bereich der Ausformungen 37 jeweils ein Andrückelement 43 mit Feder 44 aufweist, dessen Oberseite 45 jeweils entsprechend der Form der Ausformungen 37 ausgeformt ist, d.h. insbesondere in Form eines Halbellipsoiden mit einer abgeflachten Kappe. Die Leiterplatte 2 und die Leiterfolie 3 werden nun in der Montagevorrichtung 4 relativ zueinander positioniert, so dass das Lotdepot der Kontaktflecken 24 der Leiterplatte 2 mit den korrespondierenden Ausformungen 37 der Leiterfolie 3 in Deckung gebracht wird. Zur genauen Positionierung der Leiterfolie 3, und damit der Ausformungen 37 der Leiterfolie 3 bezüglich der Kontaktflecken 24 der Leiterbahnstruktur 22 der Leiterplatte 2, weist die Montagevorrichtung 4 beispielsweise Positionierhilfen 46 auf; diese Positionierhilfen 46 sind beispielsweise als auf der Oberseite 47 der Auflagevorrichtung 42 angeordnete Positionierstifte ausgebildet, die in Durchbrüche der Leiterfolie 3 und in Aufnehmungen in der Leiterplatte 2 eingreifen. Aufgrund der Federwirkung des Andrückelements 43 werden die Ausformungen 37 der Leiterfolie 3 gegen die korrespondierenden Lotdepots der Kontaktflecken 24 gedrückt, so dass sich die beiden Kontaktflächen Ausformung 37 der Leiterfolie 3 und Kontaktfleck 24 der Leiterplatte 2 an einer zu bildenden Kontaktstelle 11 gegenseitig berühren. Hierdurch und aufgrund der Anpassung von Form und Dimensionierung der beiden Kontaktflächen Ausformung 37 der Schaltfolie 31 und Kontaktfleck 24 der Leiterplatte 2 und auch der beiden elektrisch zu verbindenden stromführenden Flächen (Leiterbahn 23 der Leiterplatte 2, Leiterbahn 36 der Leiterfolie 3) wird ein definierter Lotfluss des Lotdepots der Kontaktflecken 24 während des Lötprozesses vorgegeben.

Mittels dieses selektiven Lötprozesses, insbesondere mittels des in Fig. 4 beispielhaft dargestellten Laserlötens, d.h. Einbringen von thermischer Energie mittels der Strahlungswärme eines durch eine Fokussiereinrichtung 49 fokussierten Laserstrahls 5, wird das Lotdepot der Kontaktflecken 24 selektiv aufgeschmolzen, wodurch eine stoffschlüssige Materialverbindung (Verschmelzung) der einander berührenden Materialien der beiden Kontaktflächen Ausformung 37 der Leiterfolie 3 und Kontaktfleck 24 der Leiterplatte 2 stattfindet, d.h. eine Verbindung des Materials des Lotdepots der Kontaktflecken 24 (beispielsweise Kupfer mit Zinn-Auflage oder Kupfer mit Blei-Zinn-Auflage) mit dem vorverzinnten Kupfer als Material der Leiterbahnstruktur 32 der Schaltfolie 31 der Leiterfolie 3 im Bereich der Ausformungen 37; beispielsweise wird das Laserlöten über eine Zeit von etwa 1.5 s bei einer Leistung von etwa 30 W angewendet. Hierdurch werden die beiden stromführenden Flächen auf der Leiterbahnstruktur 22 der Leiterplatte 2 und auf der Leiterbahnstruktur 32 der Leiterfolie 31 elektrisch leitend verbindenden Kontaktstellen 11 ausgebildet.

Als elektronische Baugruppe 1 mit dem Verbund aus Leiterplatte 2 und Leiterfolie 3 ist beispielsweise ein in der Seitentüre eines Kraftfahrzeugs integriertes Türsteuergerät 1 vorgesehen, das beispielsweise u.a. für die Ansteuerung der Fensterheber, Außenspiegel, Leuchten und Airbags des Kraftfahrzeugs dient. Die Leiterplatte 2 zur Aufnahme mehrerer elektronischer Bauteile der elektronischen Baugruppe 1 besteht beispielsweise aus glasfaserverstärktem Epoxydharz (FR4) und besitzt beispielsweise die Abmessungen von 60 mm x 70 mm x 1,6 mm. Die Leiterfolie 3 besitzt beispielsweise die Abmessungen von 0,6 mm x 40 mm x 500 mm. Durch die beschriebene Lötverbindung werden mehrere Kontaktstellen 24 gebildet, an denen die Leiterbahnstruktur 32 der Leiterfolie 3 mit der Leiterbahnstruktur 22 der Leiterplatte 2 elektrisch leitend verbunden wird. Durch die Leiterfolie 3 wird eine externe Anschlussmöglichkeit für das Türsteuergerät 1 bereitgestellt, insbesondere durch Ausbildung von Anschlusskontakten auf der Leiterfolie 3, beispielsweise durch Crimpen von Anschlusskontakten auf die Schaltfolie 31 der Leiterfolie 3. Zur externen Kontaktierung des Türsteuergeräts 1 können beispielsweise mehrere Anschlusskontakte zu einem Gehäuseanschluss zusammengefasst werden, an dem beispielsweise ein Anschlussstecker zur Verbindung des Türsteuergeräts 1 mit weiteren Bauteilen und/oder mit elektronischen Baugruppen und/oder mit Spannungsquellen zur Spannungsversorgung angeschlossen werden kann. Beispielsweise wird das Türsteuergerät 1 über einen Anschlussstecker mit Bedienelementen des Kraftfahrzeugs verbunden.

### Bezugszeichenliste

- 1: Elektronische Baugruppe (Türsteuergerät)
- 2: Leiterplatte
- 3: Leiterfolie
- 4: Montagevorrichtung
- 5: Laserstrahl
- 6: Elektronische Bauteile
- 11: Kontaktstelle
- 21: Oberflächenseite der Leiterplatte
- 22: Leiterbahnstruktur
- 23: Leiterbahnen
- 24: Kontaktfleck
- 31: Schaltfolie (Schaltungsträger)
- 32: Leiterbahnstruktur
- 33: Erste Isolationsfolie(Trägerkörper)
- 34: Kontaktierungsbereich
- 35: Zweite Isolationsfolie (Abdeckung)
- 36: Leiterbahn
- 37: Ausformung / Ein-/Ausprägungen
- 38: Freischnitt
- 39: Oberseite der Leiterfolie
- 41: Niederhalter
- 42: Auflagevorrichtung
- 43: Andrückelement
- 44: Feder Andrückelement
- 45: Oberseite Andrückelement
- 46: Positionierhilfen
- 47: Oberseite Auflagevorrichtung
- 48: Abgewinkelter Bereich der Leiterbahn 36
- 49: Fokussiereinrichtung des Laserstrahls

## Patentansprüche

1. Elektronische Baugruppe (1) mit einer eine Leiterbahnstruktur (22) aufweisenden Leiterplatte (2) und mit einer eine Leiterbahnstruktur (32) mit Leiterbahnen (36) aufweisenden flexiblen Leiterfolie (3), die in einem Kontaktierungsbereich (34) der Leiterbahnen (36) mittels eines dort durch einen selektiven Lötprozess aufgeschmolzenen Lötdepots eines Kontaktflecks (24) verbunden sind, wobei die Leiterfolie (3) mit einer konkaven Präge-Ausformung versehen ist;
**dadurch gekennzeichnet,**
- **dass** die Ausformung (37) eine auf der zur Leiterplatte (2) weisenden Oberseite (39) der Leiterfolie (3) als Abstandshalter überstehende Kappe ist,
- **dass** sich die beiden Kontaktflächen Ausformung (37) der Leiterfolie (3) und Kontaktfleck (24) der Leiterplatte (2), an einer Kontaktstelle (11) gegenseitig berühren,
- wobei das Lotmittel des aufgeschmolzenen Lotdepots des Kontaktflecks einen umlaufenden Meniskus bildet,
- und wobei eine stoffschlüssige Materialverbindung der beiden Kontaktflächen Ausformung (37) und Kontaktfleck (24) vorhanden ist.

2. Baugruppe nach Anspruch 1, **dadurch gekennzeichnet,**
**dass** Form und/oder Größe der Kontaktflecken (24) auf der Leiterbahnstruktur (22) der Leiterplatte (2) in Abhängigkeit der Form und/oder Größe der Ausformungen (37) in der Leiterfolie (3) gewählt sind.

3. Baugruppe nach Anspruch 1 oder 2, **dadurch gekennzeichnet,**
**dass** die Ausformungen (37) in der Leiterfolie (3) eine runde, insbesondere eine halbellipsoidische Form aufweisen, z. B. die Form eines Halbellipsoiden mit abgeflachte Kappe.

4. Baugruppe nach einem der Ansprüche 1 bis 3, **dadurch gekennzeichnet,**
**dass** zumindest im Bereich der Ausformungen (37) in der Leiterfolie (3) die Breite der Leiterbahnen (36) entsprechend der Breite der Leiterbahnen (23) der Leiterbahnstruktur (22) der Leiterplatte (2) gewählt ist.

5. Baugruppe nach einem der Ansprüche 1 bis 4; **dadurch gekennzeichnet,**
**dass** bei mehreren nebeneinander liegenden Leiterbahnen (36) der Leiterbahnstruktur (32) der Leiterfolie (3) zumindest im Bereich der Ausformungen (37) Freischnitte (38) in die Leiterfolie (3) zur Trennung der Leiterbahnen (36) eingebracht sind.

6. Baugruppe nach einem der Ansprüche 1 bis 5, **dadurch gekennzeichnet,**
**dass** die Leiterfolie (3) eine erste Isolationsfolie (33) als Trägerkörper, eine Schaltfolie (31) mit der Leiterbahnstruktur (32) als Schaltungsträger und eine den Schaltungsträger abdeckende zweite Isolationsfolie (35) als Abdeckung aufweist.

7. Baugruppe nach Anspruch 6, **dadurch gekennzeichnet,**
**dass** eine flexible Leiterplatte als Schaltungsträger (31) und Trägerkörper (33) der Leiterfolie (3) vorgesehen ist, die von einer Isolationsfolie (35) als Abdeckung abgedeckt ist.

8. Baugruppe nach einem der Ansprüche 1 bis 7, **dadurch gekennzeichnet,**
**dass** auf der Leiterfolie (3) Anschlusskontakte zur externen Kontaktierung der elektronischen Baugruppe (1) ausgebildet sind, wobei mehrere Anschlusskontakte zur Bildung eines Gehäuseanschlusses zusammenfassbar sind.

9. Baugruppe nach Anspruch 1, **dadurch gekennzeichnet, dass** die Leiterplatte (2) aus glasfaserverstärktem Epoxydharz besteht.

10. Baugruppe nach mindestens einem der Ansprüche 1 bis 9, **dadurch gekennzeichnet,**
**dass** die mehreren nebeneinander liegenden Leiterbahnen (36) der Leiterbahnstruktur (32) die Leiterfolie (3) zumindest im Bereich der Ausformung (37) Freischnitte (38) zur Trennung der Leiterbahnen (36) eingebracht sind.

11. Leiterfolie (3) geeignet zum Einsatz in eine elektronische Baugruppe nach den Ansprüchen 1 bis 9, mit einem Trägerkörper (33), einem Schaltungsträger (31) in den eine Leiterbahnstruktur (32) eingebracht ist und einer den Schaltungsträger abdeckenden Abdeckung (35), wobei die Leiterfolie mit einer konkaven Präge-Ausformung versehen ist,
**dadurch gekennzeichnet,**
- **dass** die Prägeausformung als an zumindest einem Ende der Leiterfolie (3) an der Leiterbahnstruktur (32) an der Oberseite der Leiterfolie (3) als Abstandshalter überstehende Ausformungen (37) in Form einer Kappe vorgesehen sind, die auf der gegenüberliegenden Unterseite der Leiterfolie (3) jeweils eine konkave Einbuchtung bilden, wobei die Ausformungen (37) eingeprägt sind und zum Beispiel die Form eines Halbellipsoiden mit einer abgeflachten Kappe aufweisen,
- und **dass** zumindest im Bereich der Ausformungen (37) der mehreren nebeneinander liegenden Leiterbahnen (36) der Leiterbahnstruktur (32) Freischnitte (38) zur Trennung der Leiterbahnen (36) eingebracht sind.

12. Leiterfolie nach Anspruch 11, **dadurch gekennzeichnet,**
**dass** die Leiterfolie (3) im Bereich des Freischnitts (38) einen mehrfach abgewinkelten Bereich (48) aufweist.

13. Verfahren zur Herstellung einer elektronischen Baugruppe (1) mit einer eine Unterbahnstruktur (22) aufweisenden Leiterplatte (2) und einer eine Leiterbahnstruktur (32) aufweisenden Leiterfolie (3), die eine die Leiterbahnstruktur (32) abdeckende Abdeckung (35) aufweist,
**dadurch gekennzeichnet,**
- **dass** die Abdeckung (35) der Leiterfolie (3) an deren Kontaktierungsbereichen (34) entfernt wird und in die Kontaktierungsbereiche (34) an der Oberseite überstehende Ausformungen (37) als Abstandshalter eingebracht, zum Beispiel eingeprägt werden;
- **dass** jeweils ein Lotdepot auf Kontaktflecken (24) der Leiterbahnstruktur (22) aufgebracht wird;
- **dass** die Leiterplatte (2) und die mit Ausformungen (37) versehene Leiterfolie (3) in ein Montagewerkzeug (4) eingebracht werden, durch die eine exakte Positionierung der Kontaktflächen der Ausformungen (37) der Leiterfolie (3) und der korrespondierenden Kontaktflecken (24) der Leiterplatte (2) erfolgt und die Ausformungen (37) gegen die korrespondierenden Kontaktflecken (24) auf der Leiterplatte (2) gedrückt werden,
- **dass** die Lotdepots mittels eines selektiven Lötprozesses, zum Beispiel mittels eines Laserstrahls (5), durch die Leiterplatte (2) hindurch erwärmt werden,
- und **dass dadurch** eine elektrisch leitende Verbindung der Leiterbahnstruktur (22) der Leiterplatte (2) und der Leiterbahnstruktur (32) der Leiterfolie (3) geschaffen wird.

14. Verfahren nach Anspruch 13, **dadurch gekennzeichnet,**
**dass** die Leiterfolie (3) in dem Montagewerkzeug (4) mittels einer Positionierhilfe (46) positioniert und die Ausformungen (37) der Leiterfolie (3) mittels einer Andrückvorrichtung (43 - 45), die im Bereich der Ausformungen (37) jeweils ein Andrückelement (43) mit Feder (44) besitzt, gegen die korrespondierenden Lotdepots an den Kontaktflecken (24) der Leiterbahnstruktur (22) der Leiterplatte (2) gedrückt werden.

## Claims

1. An electronic module (1) with a printed circuit board (2) having a conducting track structure (22), and with a flexible conducting foil (3) having a conducting track structure (32) with conducting tracks (36), which in a contact region (34) of the conducting tracks (36) are joined by means of a solder deposit of a contact spot (24), fused on there by a selective soldering process, wherein the conducting foil (3) is provided with a concave impressed moulding,
**characterised in that,**
- the moulding (37) is a cap, projecting from the upper side (39) of the conducting foil (3), facing towards the printed circuit board (2), as a spacer.
- the two contact surfaces, the moulding (37) of the conducting foil (3) and the contact spot (24) of the printed circuit board (2), male contact with each other at a contact location (11), wherein
- the soldering material of the fused-on solder deposit of the contact spot forms a peripheral meniscus,
- and a bonded material connection of the two contact surfaces, the moulding (37) and the contact spot (24), is present.

2. The module according to Claim 1, **characterised in that** the shape and/or size of the contact spots (24) on the conducting track structure (22) of the printed circuit board (2) are selected as a function of the shape and/or size of the mouldings (37) in the conducting foil (3).

3. The module according to Claim 1 or 2, ***characterised in that*** the mouldings (37) in the conducting foil (3) have a round, in particular a semi-ellipsoidal shape, e.g. the shape of a semi-ellipsoid with a flattened cap.

4. The module according to one of the Claims 1 to 3, ***characterised in that*** the width of the conducting tracks (36), at least in the region of the mouldings (37) in the conducting foil (3), is selected in accordance with the width of the conducting tracks (23) of the conducting track structure (22) of the printed circuit board (2).

5. The module according to one of the Claims 1 to 4, ***characterised in that*** with a plurality of conducting tracks (36) of the conducting track structure (32) of the conducting foil (3) lying alongside one another, cut-outs (38) are introduced into the conducting foil (3), at least in the region of the mouldings (37), to separate the conducting tracks (36).

6. The module according to one of the Claims 1 to 5, ***characterised in that*** the conducting foil (3) has as a covering a first insulation foil (33) as a supporting body, a circuit foil (31) with the conducting track structure (32) as a circuit support, and a second insulation foil (35) covering the circuit support.

7. The module according to Claim 6, ***characterised in that*** a flexible printed circuit board is provided as a circuit support (31) and a supporting body (33) of the conducting foil (3), which is covered by an insulation foil (35) as a covering.

8. The module according to one of the Claims 1 to 7, ***characterised in that*** on the conducting foil (3) connecting contacts are formed to provide external contacts for the electronic module (1), wherein a plurality of connecting contacts can be grouped together to form a housing connection.

9. The module according to Claim 1, ***characterised in that*** the printed circuit board (2) consists of a glass fibre reinforced epoxy resin.

10. The module according to at least one of the Claims 1 to 9, ***characterised in that*** in the plurality of conducting tracks (36) of the conducting track structure (32) of the conducting foil (3) lying alongside one another, cut-outs (38) are introduced to separate the conducting tracks (36), at least in the region of the mouldings (37).

11. A conducting foil (3) suitable for use in an electronic module according to the Claims 1 to 9, with a supporting body (33), a circuit support (31) into which a conducting track structure (32) is introduced, and a cover (35) covering the circuit support, wherein the conducting foil is provided with a concave impressed moulding,
***characterised in that**,*
- the impressed mouldings are provided as mouldings (37), projecting from the upper side of the conducting foil (3), at least at one end of the conducting foil (3) on the conducting track structure (32), as spacers in the form of a cap, which mouldings on the opposing lower side of the conducting foil (3) in each case form a concave indentation, wherein the mouldings (37) are impressed, and have for example the shape of a semi-ellipsoid with a flattened cap,
- and at least in the region of the mouldings (37) of the plurality of conducting tracks (36) of the conducting track structure (32) lying alongside one another, cut-outs (38) are introduced to separate the conducting tracks (36).

12. The conducting foil according to Claim 11, ***characterised in that*** the conducting foil (3) has a multiply-angled region (48) in the region of the cut-out (38).

13. A method for the manufacture of an electronic module (1) with a printed circuit board (2) having a sub-track structure (22), and a conducting foil (3) having a conducting track structure (32), which has a covering (35) covering the conducting track structure (32),
***characterised in that**,*
- the covering (35) of the conducting foil (3) is removed at its contact regions (34), and mouldings (37) projecting from the upper side are introduced as spacers, for example, are impressed in, into the contact regions (34);
- in each case a solder deposit is applied to contact spots (24) of the conducting track structure (22);
- the printed circuit board (2) and the conducting foil (3) provided with mouldings (37) are introduced into an assembly tool (4), by means of which an exact positioning of the contact surfaces of the mouldings (37) of the conducting foil (3) and the corresponding contact spots (24) of the printed circuit board (2) takes place, and the mouldings (37) are pressed against the corresponding contact spots (24) on the printed circuit board (2),
- the solder deposits are heated through the printed circuit board (2) by means of a selective soldering process, for example, by means of a laser beam (5),
- and thereby an electrically conducting connection of the conducting track structure (22) of the printed circuit board (2) and the conducting track structure (32) of the conducting foil (3) is created.

14. The method according to Claim 13, ***characterised in that**,* the conducting foil (3) is positioned in the assembly tool (4) using a positioning aid (46), and the mouldings (37) of the conducting foil (3) are pressed against the corresponding solder deposits on the contact spots (24) of the conducting track structure (22) of the printed circuit board (2) using a pressure application device (43 - 45), which in the region of the mouldings (37) in each case possesses a pressure application element (43) with a spring (44).

## Revendications

1. Ensemble (1) électronique comprenant une plaque de circuits imprimés (2) présentant une structure de piste conductrice (22) et un film conducteur (3) flexible présentant une structure de piste conductrice (32) avec des pistes conductrices (36), qui sont reliées dans une zone de mise en contact (34) des pistes conductrices (36) au moyen d'un dépôt de brasage, fondu à cet endroit par un processus de brasage sélectif, d'un point de contact (24), le film conducteur (3) étant doté d'une partie formée à estamper concave,
***caractérisé en ce que***
- la partie formée (37) est un capuchon dépassant comme écarteur sur le côté supérieur (39), dirigé vers la plaque de circuits imprimés (2), du film conducteur (3),
- **en ce que** les deux surfaces de contact de la partie formée (37) du film conducteur (3) et du point de contact (24) de la plaque de circuits imprimés (2) se touchent réciproquement en un point de contact (11),
- le moyen de brasage du dépôt de brasage fondu du point de contact formant un ménisque périphérique,
- et une liaison de matériau à adhésion par matière des deux surfaces de contact partie formée (37) et point de contact (24) étant présente.

2. Ensemble selon la revendication 1, ***caractérisé en ce que*** la forme et/ou la grandeur des points de contact (24) sur la structure de piste conductrice (22) de la plaque de circuits imprimés (2) sont choisies en fonction de la forme et/ou de la grandeur des parties formées (37) dans le film conducteur (3).

3. Ensemble selon la revendication 1 ou 2, ***caractérisé en ce que*** les parties formées (37) dans le film conducteur (3) présentent une forme ronde, en particulier une forme hémi-ellipsoïdale, par exemple la forme d'une demi-ellipsoïde avec capuchon aplati.

4. Ensemble selon l'une quelconque des revendications 1 à 3, ***caractérisé en ce que*** au moins dans la zone des parties formées (37) dans le film conducteur (3), la largeur des pistes conductrices (36) est choisie en fonction de la largeur des pistes conductrices (23) de la structure de piste conductrice (22) de la plaque de circuits imprimés (2).

5. Ensemble selon l'une quelconque des revendications 1 à 4, ***caractérisé en ce que**,* avec plusieurs pistes conductrices (36) juxtaposées de la structure de piste conductrice (32) du film conducteur (3), au moins dans la zone des parties formées (37), des découpes libres (38) sont introduites dans le film conducteur (3) pour la séparation des pistes conductrices (36).

6. Ensemble selon l'une quelconque des revendications 1 à 5, ***caractérisé en ce que*** le film conducteur (3) présente un premier film d'isolation (33) comme corps support, un film de commutation (31) avec la structure de piste conductrice (32) comme support de circuit et un second film d'isolation (35), recouvrant le support de circuit, comme revêtement.

7. Ensemble selon la revendication 6, ***caractérisé en ce que*** une plaque de circuits imprimés flexible est prévue comme support de circuit (31) et corps support (33) du film conducteur (3), qui est recouvert d'un film d'isolation (35) comme revêtement.

8. Ensemble selon l'une quelconque des revendications 1 à 7, ***caractérisé en ce que*** des contacts de raccordement sont réalisés sur le film conducteur (3) pour la mise en contact externe avec l'ensemble (1) électronique, plusieurs contacts de raccordement pouvant être regroupés pour former un branchement de boîtier.

9. Ensemble selon la revendication 1, ***caractérisé en ce que*** la plaque de circuits imprimés (2) est à base de résine époxy renforcée de fibre de verre.

10. Ensemble selon au moins l'une quelconque des revendications 1 à 9, ***caractérisé en ce que*** avec plusieurs pistes conductrices (36) juxtaposées de la structure de piste conductrice (32) du film conducteur (3), au moins dans la zone de la partie formée (37), des découpes libres (38) sont introduites pour la séparation des pistes conductrices (36).

11. Film conducteur (3) approprié pour une utilisation dans un ensemble électronique selon les revendications 1 à 9, doté d'un corps support (33), d'un support de circuit (31) dans lequel une structure de piste conductrice (32) est introduite et d'un revêtement (35) recouvrant le support de circuit, le film conducteur étant doté d'une partie formée à estamper concave,
***caractérisé en ce que***
- la partie formée à estamper est prévue sous la forme d'un capuchon comme parties formées (37) dépassant comme écarteurs sur au moins une extrémité du film conducteur (3) sur la structure de piste conductrice (32) sur le côté supérieur du film conducteur (3), lesquelles parties forment à chaque fois une partie rentrante concave sur le côté opposé du film conducteur (3), les parties formées (37) étant incrustées et présentent par exemple la forme d'une demi-ellipsoïde avec un capuchon aplati,
- et **en ce que**, au moins dans la zone des parties formées (37) des plusieurs pistes conductrices (36) juxtaposées de la structure de piste conductrice (32), des découpes libres sont introduites pour la séparation des pistes conductrices (36).

12. Film conducteur selon la revendication 11, ***caractérisé en ce que*** le film conducteur (3) présente une zone (48) plusieurs fois coudée dans la zone de la découpe libre (38).

13. Procédé pour fabriquer un ensemble (1) électronique avec une plaque de circuits imprimés (2) présentant une structure de sous-bande (22) et un film conducteur (3) présentant une structure de piste conductrice (32), qui présente un revêtement (35) recouvrant la structure de piste conductrice (32),
***caractérisé en ce que***
- le revêtement (35) du film conducteur (3) est enlevé sur ses zones de mise en contact (34) et des parties formées (37) dépassant sur le côté supérieur étant introduites, par exemple incrustées comme écarteurs, dans les zones de mise en contact (34) ;
- **en ce que**, à chaque fois, un dépôt de brasage est appliqué sur des points de contact (24) de la structure de piste conductrice (22) ;
- **en ce que** la plaque de circuits imprimés (2) et le film conducteur (3) doté de parties formées (37) sont introduits dans un outil de montage (4), par lesquels on a un positionnement exact des surfaces de contact des parties formées (37) du film conducteur (3) et des points de contact (24) correspondants de la plaque de circuits imprimés (2) et les parties formées (37) sont pressées contre les points de contact (24) correspondants sur la plaque de circuits imprimés (2)
- **en ce que** les dépôts de brasage sont réchauffés au moyen d'un processus de brasage sélectif, par exemple au moyen d'un faisceau laser (5), à travers la plaque de circuits imprimés (2),
- et **en ce que** de ce fait une liaison électroconductrice entre la structure de piste conductrice (22) de la plaque de circuits imprimés (2) et la structure de piste conductrice (32) du film conducteur (3) est créée.

14. Procédé selon la revendication 13, ***caractérisé en ce que*** le film conducteur (3) est positionné dans l'outil de montage (4) au moyen d'une aide de positionnement (46) et les parties formées (37) du film conducteur (3) sont pressées, au moyen d'un dispositif d'appui (43-45), qui présente dans la zone de chacune des parties formées (37) un élément d'appui (43) avec ressort (44), contre les dépôts de brasage correspondants sur les points de contact (24) de la structure de piste conductrice (22) de la plaque de circuits imprimés (2).
